(19) Europäisches Patentamt / European Patent Office / Office européen des brevets

(11) **EP 3 290 930 B1**

(12) **FASCICULE DE BREVET EUROPEEN**

(45) Date de publication et mention
de la délivrance du brevet:
**02.01.2019 Bulletin 2019/01**

(51) Int Cl.:
***G01R 15/18*** *(2006.01)*   ***G01R 19/00*** *(2006.01)*

(21) Numéro de dépôt: **17188392.9**

(22) Date de dépôt: **29.08.2017**

(54) **CAPTEUR DE MESURE DE COURANT DE TYPE TORE DE ROGOWSKI, DISPOSITIF DE MESURE ET DISJONCTEUR ELECTRIQUE COMPORTANT UN TEL CAPTEUR, ET PROCEDE DE BOBINAGE D'UN TEL CAPTEUR**

STROMMESSSENSOR VOM TYP ROGOWSKI-SPULE, MESSVORRICHTUNG UND ELEKTRISCHER TRENNSCHALTER, DER EINEN SOLCHEN SENSOR UMFASST, UND SPULENWICKLUNGSVERFAHREN EINES SOLCHEN SENSORS

ROGOWSKI COIL TYPE SENSOR FOR MEASURING CURRENT, MEASURING DEVICE AND ELECTRICAL CIRCUIT BREAKER INCLUDING SUCH A SENSOR, AND METHOD FOR WINDING SUCH A SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.08.2016 FR 1658081**

(43) Date de publication de la demande:
**07.03.2018 Bulletin 2018/10**

(73) Titulaire: **Schneider Electric Industries SAS**
**92500 Rueil Malmaison (FR)**

(72) Inventeurs:
• **OLIVIER, Audrey**
 **38050 Grenoble Cedex 09 (FR)**
• **BRUNEL, Philippe**
 **38050 Grenoble Cedex 09 (FR)**
• **BUFFAT, Sébastien**
 **38050 Grenoble Cedex 09 (FR)**
• **GRANIER, David**
 **38050 Grenoble Cedex 09 (FR)**
• **SICARD, Stéphane**
 **38050 Grenoble Cedex 09 (FR)**
• **ROUBARDEAU, François**
 **38050 Grenoble Cedex 09 (FR)**

(74) Mandataire: **Tripodi, Paul**
**Schneider Electric Industries SAS**
**Service Propriété Industrielle**
**World Trade Center / 38EE1**
**5 Place Robert Schuman**
**38050 Grenoble Cedex 09 (FR)**

(56) Documents cités:
**US-A1- 2008 079 418     US-A1- 2011 043 190**
**US-A1- 2015 028 853**

**Description**

## DOMAINE TECHNIQUE

L'invention concerne un capteur de mesure de courant de type tore de Rogowski comportant un support en matériaux amagnétique et au moins un bobinage secondaire enroulé sur ledit support pour fournir un signal électrique représentatif d'un courant circulant dans un conducteur traversant l'intérieur du tore ainsi, qu'un procédé de bobinage d'un tel capteur.

L'invention concerne aussi un dispositif de mesure et un disjoncteur électrique comportant un tel capteur.

## ETAT DE LA TECHNIQUE

Les tores de Rogowski sont généralement connus dans le domaine des disjoncteurs de puissance équipés de déclencheurs électroniques. Ils sont utilisés pour la qualité de leur linéarité et grande dynamique de mesure puisqu'il ne comporte pas de circuit magnétique pouvant être saturé. Ainsi, la précision est directement liée à la régularité du bobinage et à la section du capteur.

Des exemples de capteurs à tores de Rogowski utilisés dans les disjoncteurs sont décrits dans les demandes de brevets EP2667205A1 et US2014132249A1. Les documents US2008/079418, US2015/028853 et US2011/043190 décrivent des tores de Rogowski à deux couches de bobinage.

Le signal de sortie d'un tore de Rogowski est donné par la formule :

$$V = \mu \, n \, S \, di/dt$$

V étant la tension du signal de sortie fournie par le tore de Rogowski, S la section d'une spire, $\mu_0$ la perméabilité n est le nombre de spires, et di/dt la dérivée d'un courant primaire par rapport au temps.

Ainsi, la tension délivrée par le tore est fonction du nombre de spires. La précision de la tension est directement liée à la qualité du bobinage.

Dans les appareils électriques à forts courant, ce type de capteurs est sensible aussi aux champs magnétiques extérieurs aux tores si le bobinage n'est pas parfait. Généralement, les capteurs à tores de Rogowski sont associés à des transformateurs de courant à circuit magnétique pour assurer l'alimentation des circuits électroniques. Ces transformateurs de courant sont connectés à des circuits de régulation à découpage qui perturbent l'environnement électromagnétique des capteurs de mesure de courant.

Certains capteurs comportent des blindages pour les rendre insensibles aux variations et perturbations externes. Cependant, ces solutions ne sont pas très efficaces lorsque les capteurs sont associés à des transformateurs de courant pour l'alimentation électrique de circuits électroniques.

## EXPOSE DE L'INVENTION

L'invention a pour but un capteur à tore de Rogowski très précis pouvant être fabriqué en série et étant peu sensible aux variations de champs électromagnétiques extérieurs, ainsi qu'un procédé de bobinage d'un tel capteur, et un dispositif de mesure et un disjoncteur comportant un tel capteur.

Selon l'invention, un capteur de mesure de courant de type tore de Rogowski est décrit dans la revendication 1.

Dans un mode de réalisation préférentiel, ledit bobinage comporte un nombre pair de couches,

- une moitié des couches étant enroulées dans un premier sens d'enroulement de la première extrémité vers la seconde extrémité opposée du bobinage, et
- l'autre moitié des couches étant enroulées dans un second sens d'enroulement de la seconde extrémité opposée du bobinage vers la première extrémité,
- la dernière couche étant une couche externe à faible densité de spires enroulée dans ledit second sens d'enroulement de la seconde extrémité opposée du bobinage vers la première extrémité.

De préférence, ledit bobinage comporte un nombre pair de couches :

- une moitié des couches étant des couches internes à haute densité de spires proches du support, et
- l'autre moitié des couches étant des couches externes à faible densité de spires comportant trois parties,
- la dernière couche étant une couche externe à faible densité de spires enroulée dans un second sens d'enroulement de la seconde extrémité opposée du bobinage à la première extrémité.

Dans un mode de réalisation particulier, ledit bobinage comporte :

- une première couche interne à haute densité de spires proche du support enroulée dans un premier sens d'enroulement de la première extrémité vers la seconde extrémité opposée du bobinage,
- une seconde couche interne à haute densité de spires proche du support enroulée dans un second sens d'enroulement de la seconde extrémité vers la première extrémité opposée du bobinage,
- une première couche externe à faible densité de spires comportant trois parties enroulée dans le premier sens d'enroulement de la première extrémité vers la seconde extrémité opposée du bobinage, et
- une seconde couche externe à faible densité de spires comportant trois parties enroulée dans un second sens d'enroulement de la seconde extrémité opposée du bobinage vers la première extrémité.

Un procédé de bobinage d'un capteur de mesure de courant tel que défini ci-dessus est décrit dans la revendication 6. De préférence, le procédé de bobinage comporte des enroulements d'un nombre pair de couches,

- une moitié des couches étant enroulées dans un premier sens d'enroulement de la première extrémité vers la seconde extrémité opposée du bobinage, et
- l'autre moitié des couches étant enroulées dans un second sens d'enroulement de la seconde extrémité opposée du bobinage vers la première extrémité,
- la dernière couche étant une couche externe à faible densité de spires enroulée dans le second sens d'enroulement de la seconde extrémité opposée du bobinage vers la première extrémité.

Avantageusement, le procédé de bobinage comporte des enroulements d'un nombre pair de couches,

- une moitié des couches étant des couches internes à haute densité de spires proches du support, et
- l'autre moitié des couches étant des couches externes à faible densité de spires,
- la dernière couche étant une couche externe à faible densité de spires enroulée dans le second sens d'enroulement de la seconde extrémité opposée du bobinage à la première extrémité.

Dans un mode de réalisation particulier, le procédé de bobinage comporte :

- l'enroulement d'au moins une première couche interne à haute densité de spires proche du support dans le premier sens d'enroulement de la première extrémité vers la seconde extrémité opposée du bobinage,
- l'enroulement d'au moins une seconde couche interne à haute densité de spires proche du support dans le second sens d'enroulement de la seconde extrémité vers la première extrémité opposée du bobinage,
- l'enroulement d'au moins une première couche externe à faible densité de spires dans le premier sens d'enroulement de la première extrémité vers la seconde extrémité opposée du bobinage, et
- l'enroulement d'au moins une seconde couche externe à faible densité de spires dans le second sens d'enroulement de la seconde extrémité opposée du bobinage vers la première extrémité.

Un dispositif de mesure de courant comportant une unité de traitement pour recevoir des signaux représentatifs de courants électriques comporte un capteur de mesure tel que défini ci-dessus connecté à l'unité de traitement pour fournir un signal de courant représentatif d'un courant circulant dans un conducteur électrique.

Un disjoncteur électrique comportant au moins un contact principal pour couper un courant dans un circuit électrique, un mécanisme de commande de l'ouverture dudit contact électrique et un dispositif de mesure et de protection fournissant un signal de commande audit mécanisme de commande comporte un capteur de mesure tel que défini ci-dessus connecté à une unité de traitement dudit dispositif de mesure et de protection.

**BREVE DESCRIPTION DES DESSINS**

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

- la figure 1 représente une première vue schématique d'un capteur selon un premier mode de réalisation de l'invention ;
- la figure 2 représente une vue d'un capteur selon un mode de réalisation de l'invention ;
- les figures 3 et 4 représentent des vue schématiques partielles des extrémités de bobinage selon deux modes de réalisation de l'invention ;
- la figure 5 représente une vue d'un support d'un bobinage d'un capteur selon un mode de réalisation de l'invention ;
- la figure 6 représente un schéma d'un disjoncteur électrique comportant un capteur selon un mode de réalisation de l'invention ;
- la figure 7 représente les étapes d'un procédé de bobinage d'un capteur selon un premier mode de réalisation de l'invention ;
- les figures 8 et 9 représentent les étapes d'un procédé de bobinage d'un capteur selon un d'autres modes de réalisation de l'invention ; et
- la figure 10 représente une photo d'une vue partielle d'un tore selon un mode de réalisation.

**DESCRIPTION DETAILLEE DE MODES DE REALISATION**

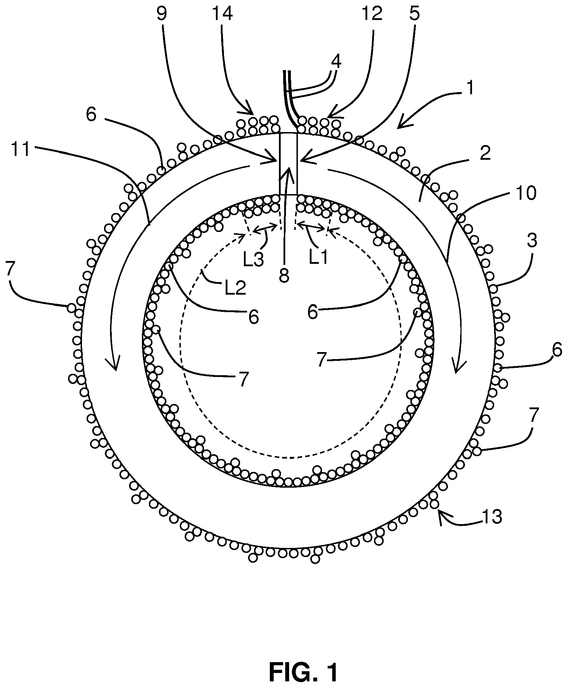

Dans la vue schématique de la figure 1, le capteur de courant 1 de type tore de Rogowski comporte un support 2 en matériaux amagnétique et au moins un bobinage secondaire 3 enroulé sur le support 1 pour fournir un signal électrique représentatif d'un courant circulant dans un conducteur traversant l'intérieur du tore.

Selon un mode de réalisation de l'invention le bobinage secondaire 3 comporte au moins deux couches dont les terminaisons électriques 4 des enroulements sont situées à une même première extrémité 5 du bobinage 3. Afin de réduire la sensibilité du bobinage aux perturbations électromagnétiques extérieures au tore, le bobinage comporte un nombre pair de couches d'enroulement de manière à ce que les sorties 4 du conducteur électrique du bobinage sortent du même coté ou de la même extrémité 5 du bobinage. Ainsi, le bobinage est enroulé dans un premier sens aller sur une première couche 6 puis dans un sens retour sur une seconde couche 7. Pour des raisons pratiques de fabrication du tore, un partie 8 sans bobinage est prévue entre la première extrémité 5 du bobinage et une seconde extrémité 9 opposée du bobinage 3. Le nombre de spires n du bobinage étant défini en fonction du signal souhaité et le nombre de couches étant pair pour éviter les perturbations, les spires sont réparties sur les couches du bobinage avec les enroulements dans le sens aller et le sens retour.

Ainsi, pour garantir une meilleure immunité aux perturbations électromagnétiques extérieures au tore, le bobinage comporte au moins une couche interne 6 à haute densité de spires proche du support 2 et enroulée dans un premier sens 10 d'enroulement de la première extrémité 5 vers la seconde extrémité 9 opposée du bobinage, et au moins une couche externe 7 à faible densité de spires comportant trois parties et enroulée dans un second sens d'enroulement 11 de la seconde extrémité 9 opposée du bobinage vers la première extrémité 5.

La première couche interne 6 proche du support est de préférence réalisée à spires jointives du coté intérieur du tore. Dans ce document, le terme couche interne signifie la ou les couches les plus proches du support et couche externe signifie la ou les couches les plus éloignées du support. Haute densité de spires signifie que le pas est entre spires jointives et espacement inférieur au diamètre du fil d'enroulement du coté intérieur du tore. Faible densité signifie un espacement entre spire supérieur au diamètre du fil de l'enroulement.

Couches à faible densité signifie que les couches sont à faible densité de manière globale, c'est-à-dire qu'elles ont des parties à faibles densité sur la majeure partie de la longueur du bobinage mais elles peuvent avoir de petites parties à haute densité. Notamment, ces parties à haute densités peuvent être situées près des extrémités pour des spires de compensation des parties sans bobinage.

Dans ce cas, la seconde couche 7 externe à faible densité comporte :

-    une première partie de compensation 12 à haute densité de spires et de faible longueur L1 proche de la première extrémité 5 du bobinage,
-    une partie centrale 13 à faible densité de spires et de grande longueur L2, et
-    une seconde partie de compensation 14 à haute densité de spires et de faible longueur L3 proche de la seconde extrémité 9 du bobinage.

Les parties de compensation 12 et 14 permettent de compenser la partie 8 sans bobinage entre les extrémités 5 et 9.

De préférence, dans une couche à faible densité, les petites parties 12 et 14 à haute densité ont une longueur de bobinage inférieure à 1/10 de la longueur du bobinage à faible densité. Par exemple (L1 + L3) < (L2/10).

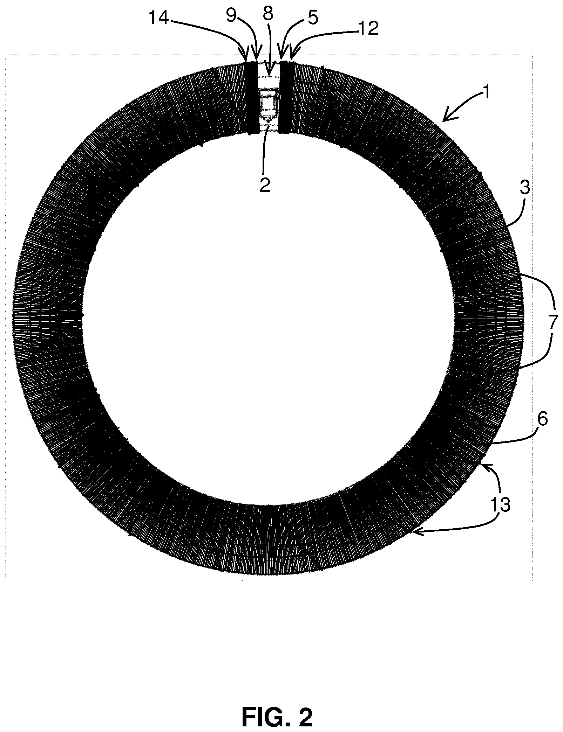

La figure 2 représente une vue d'un capteur selon le mode de réalisation de la figure 1. La première couche interne 6 est bobinée à spires jointives sur le support 2 du tore. La seconde couche comporte une première partie de compensation 12 à spires jointives, une partie centrale à faible densité 13 dont les spires sont réparties sur le corps du tore avec un grand intervalle entre les spires, et une seconde partie de compensation 14 à spires jointives. Les parties de compensation compensent les spires manquantes dans la partie intermédiaire 8 sans bobinage. La longueur des parties de compensation 12 et 14 à haute densité ou à spires jointives est de préférence de quelques millimètres. La partie centrale à faible densité a de préférence une longueur de plusieurs centimètres repartie sur la circonférence du tore.

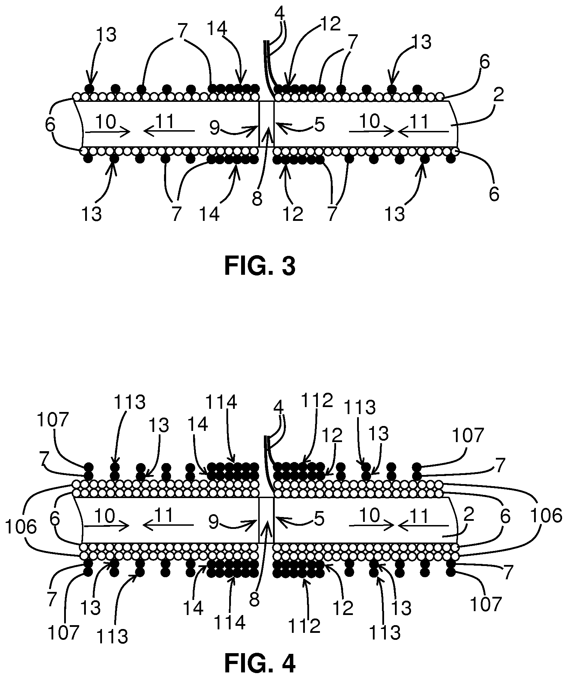

La figures 3 représente une vue schématique linéaire partielle des extrémités de bobinage selon le premier mode de réalisation. La vue partielle représente la même configuration que celle de la figure 1 avec une couche interne 6 à haute densité de spires proches du support enroulé dans un premier sens d'enroulement 10, et une couche externe 7 à faible densité de spires comportant trois parties et enroulée dans le second sens d'enroulement 11 de la seconde extrémité 9 opposée du bobinage vers la première extrémité 5.

Dans des capteurs de mesures nécessitant un nombre de spires très élevé, le bobinage est réparti sur plusieurs couches. Ainsi, selon des modes de réalisation de l'invention à plusieurs couches, le bobinage comporte un nombre pair de couches.

Avantageusement, les couches sont réparties de la manière suivante :

-    une moitié des couches sont enroulées dans un premier sens d'enroulement 10 de la première extrémité 5 vers la seconde extrémité 9 opposée du bobinage,
-    l'autre moitié des couches sont enroulées dans un second sens d'enroulement 11 de la seconde extrémité 9 opposée du bobinage vers la première extrémité 5, et
-    la dernière couche est une couche externe 7, 107 à faible densité de spires comportant trois parties et enroulée dans un second sens d'enroulement 11 de la seconde extrémité 9 opposée du bobinage vers la première extrémité 5.

Le nombre pair de couches sera de préférence aussi réparti de la manière suivante

-    une moitié des couches sont des couches internes 6, 106 à haute densité de spires proches du support 2,
-    l'autre moitié des couches sont des couches externes 7, 107 à faible densité de spires comportant trois parties,

- la dernière couche est une couche externe 7, 107 à faible densité de spires comportant trois parties enroulées dans un second sens d'enroulement 11 de la seconde extrémité 9 opposée du bobinage vers la première extrémité 5.

La figures 4 représente une vue schématique partielle des extrémités de bobinage selon un second mode de réalisation de l'invention d'un capteur à quatre couches. Dans ce cas, le bobinage à quatre couches est constitué de la manière suivante :

- la première couche est une première couche interne 6 à haute densité de spires proche du support enroulée dans le premier sens d'enroulement 10 de la première extrémité 5 vers la seconde extrémité 9 opposée du bobinage,
- la seconde couche est une seconde couche interne 106 à haute densité de spires proche du support enroulée dans le second sens d'enroulement 11 de la seconde extrémité 9 vers la première extrémité 5 opposée du bobinage,
- la troisième couche est une première couche externe 7 à faible densité de spires comportant trois parties enroulée dans le premier sens d'enroulement 10 de la première extrémité 5 vers la seconde extrémité 9 opposée du bobinage, et
- la quatrième est une seconde couche externe 107 à faible densité de spires comportant trois parties enroulée dans le second sens d'enroulement 11 de la seconde extrémité 9 opposée du bobinage vers la première extrémité 5.

Sur la figure 4, les troisième et quatrième couches sont montrées schématiquement de manière parfaitement superposées pour la clarté de la description. Cependant, puisque les spires sont peu denses, dans la réalité la quatrième couche peut descendre localement et partiellement au niveau de la troisième tout en restant qualifiée de quatrième couche.

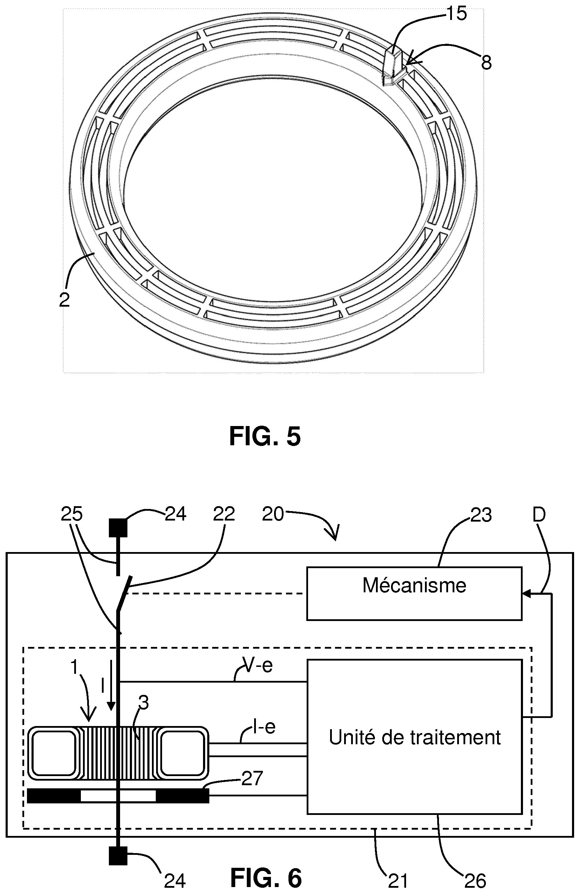

La figure 5 représente une vue d'un support en matériau amagnétique d'un bobinage pour un capteur selon un mode de réalisation de l'invention. La partie intermédiaire sans bobinage se trouvera au niveau d'un ergot 15 de fixation ou de blocage des fils 4 de sortie du bobinage.

La figure 6 représente un schéma d'un disjoncteur électrique 20 comportant un capteur 1 selon un mode de réalisation de l'invention associé à un dispositif 21 de mesure et de protection. Le disjoncteur électrique 20 comporte au moins un contact principal 22 pour couper un courant I dans un circuit électrique, un mécanisme 23 de commande de l'ouverture dudit contact électrique 22 et le dispositif 21 de mesure et de protection pour fournir un signal de commande D audit mécanisme 22 de commande. Le disjoncteur comporte aussi des bornes électriques 24 de puissance pour raccorder des conducteurs électriques externes et des conducteurs 25 de liaisons internes entre le contact principal 22 et les bornes 23. Au moins un capteur 1 de courant tel que décrit ci-dessus est disposé autour d'un conducteur primaire 25 du disjoncteur tel qu'un conducteur de liaison 25 entre une borne 24 et un contact principal 22. Le capteur de courant 1 est connecté à une unité de traitement 26 du dispositif 21 de mesure et de protection pour fournir des signaux représentatifs I-e d'un courant électrique circulant dans le conducteur primaire I. Ainsi, l'unité de traitement reçoit des signaux I-e représentatifs de courant électrique du capteur 1, effectue le traitement des signaux de courant, effectue les fonctions de protections et des signalisations et si besoin fourni un signal ou un ordre de déclenchement D au mécanisme 23 pour ouvrir les contacts 22 du disjoncteur. Un transformateur de courant 27 à circuit magnétique est connecté à l'unité de traitement pour fournir une énergie électrique destinée au fonctionnement des circuits électroniques.

Le bobinage secondaire 3 est connecté à une entrée de l'unité de traitement 26 pour fournir le signal I-e de mesure de courant. L'unité de traitement peut aussi recevoir un signal de mesure de tension V-e depuis le conducteur primaire 25. Dans ce cas, l'unité de traitement peut faire aussi le traitement et le calcul de l'énergie et/ou de la puissance électrique avec une très grande précision.

Sur la figure 6, uniquement un disjoncteur à une phase ou pôle est représenté. Cependant, l'invention s'applique aussi à des disjoncteurs multipolaires notamment à des disjoncteurs triphasés. Dans ce cas, chaque pôle protégé comporte un capteur de courant tel que défini ci-dessus.

Le dispositif de mesure et de protection 15 comportant le capteur 21 et l'unité de traitement 18, peut être un déclencheur électronique pour disjoncteur mais également un relais ou un module de protection et/ou de mesure de puissance et/ou d'énergie électrique.

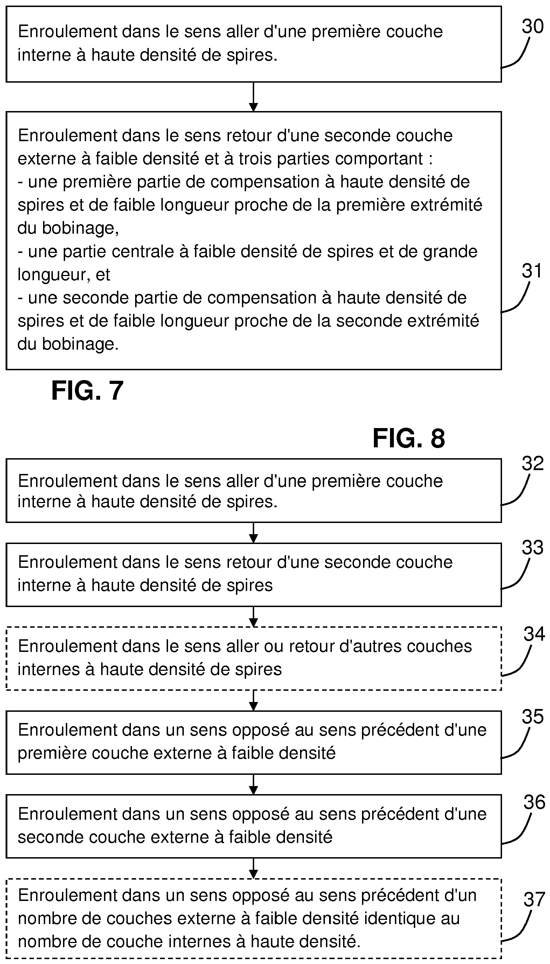

La figure 7 représente les étapes d'un procédé de bobinage d'un capteur de mesure de courant selon un premier mode de réalisation de l'invention. Le procédé de bobinage comporte une première étape 30 d'enroulement d'au moins une couche interne à haute densité de spires proche du support dans un premier sens d'enroulement 10 de la première extrémité 5 vers une seconde extrémité 9 opposée du bobinage. Le premier sens d'enroulement 11 sera nommé sens aller. La haute densité de spires est de préférence à spires jointives. Dans une seconde étape 31 d'enroulement, au moins une couche externe à faible densité de spires comportant trois parties est enroulée dans un second sens d'enroulement 11 de la seconde extrémité 9 opposée du bobinage vers la première extrémité 5. Le second sens de bobinage sera nommé sens retour. La couche externe à faible densité comporte :

- une première partie de compensation 12 à haute densité de spires et de faible longueur L1 proche de la première extrémité 5 du bobinage,

- une partie centrale 13 à faible densité de spires et de grande longueur, et
- une seconde partie de compensation 14 à haute densité de spires et de faible longueur L2 proche de la seconde extrémité 9 du bobinage.

Pour les procédés selon l'invention, d'enroulement à plusieurs couches l'enroulement comporte un nombre pair de couches réparties de la manière suivante

- une moitié des couches sont enroulées dans un premier sens aller d'enroulement 10 de la première extrémité 5 vers la seconde extrémité 9 opposée du bobinage,
- l'autre moitié des couches sont enroulées dans un second sens retour d'enroulement 11 de la seconde extrémité 9 opposée du bobinage vers la première extrémité 5, et
- la dernière couche est une couche externe 7, 107 à faible densité de spires comportant trois parties et enroulée dans un second sens d'enroulement 11 de la seconde extrémité 11 opposée du bobinage vers la première extrémité 5.

Par exemple avec ce procédé il est possible d'avoir plus de couches à haute densité et moins de couche à faible densité à condition que la dernière couche soit à faible densité.

Dans les procédés, le nombre pair de couches sera de préférence aussi réparti de la manière suivante :

- une moitié des couches sont des couches internes 6, 106 à haute densité de spires proches du support 2,
- l'autre moitié des couches sont des couches externes 7, 107 à faible densité de spires comportant trois parties,
- la dernière couche est une couche externe 7, 107 à faible densité de spires comportant trois parties enroulée dans le sens retour.

La figure 8 représente les étapes d'un procédé de bobinage d'un capteur selon un mode de réalisation multicouches. Le procédé comporte, une première étape 32 d'enroulement d'une première une couche interne à haute densité de spires proche du support enroulé dans le sens aller, puis une seconde étape 33 d'enroulement d'une première une couche interne à haute densité de spires proche du support enroulé dans le sens retour. Une étape 34 montre d'autres étapes possibles de couches internes à hautes densité de spires. Le procédé comporte aussi une étape 35 d'enroulement d'une première une couche externe à faible densité de spires enroulé dans le sens opposé au sens de sa couche précédente. D'autres couches externes à faible densité de spires enroulées dans le sens opposé au sens de leur couche précédente peuvent être enroulées à une ou des étapes 36. La dernière étape 35 ou 36 enroulera dans tous les cas une couche externe à faible densité de spires dans le sens retour.

L'étape 37 montre un cas où le nombre des couches externes sont à faible densité est égal au nombre de couches internes à haute densité. Le sens des enroulements est alterné aller et retour.

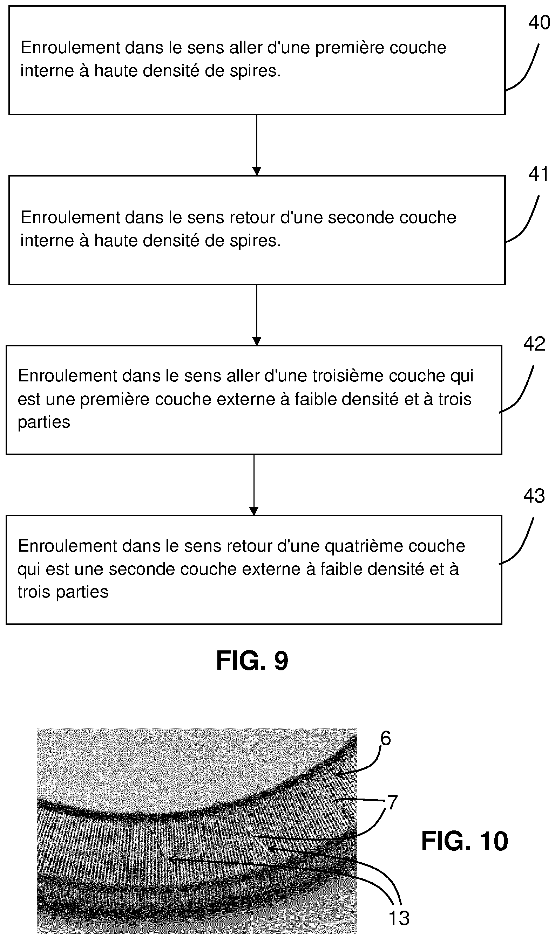

La figure 9 représente les étapes d'un procédé de bobinage d'un capteur selon un mode de réalisation préféré à quatre couches. Dans ce procédé, il y a d'abords une première étape 40 d'enroulement d'une une première couche interne 6 à haute densité de spires proche du support dans un premier sens d'enroulement aller 10, et une seconde étape 41 d'enroulement d'une une seconde couche interne 106 à haute densité de spires proche du support dans un second sens retour 11. Ensuite, il y a une troisième étape 42 d'enroulement d'une première couche externe 7 à faible densité de spires dans le premier sens d'enroulement aller 10, et une quantième étape 43 d'enroulement d'une seconde couche externe 107 à faible densité de spires dans le second sens d'enroulement retour 11.

Une photographie d'une partie d'un capteur selon un mode de réalisation est montrée sur la figure 10. Le bobinage 3 est enroulé à haute densité de spires sur la première couche 6 et à faible densité de spire sur la seconde couche 7. Des spires de la partie centrale 13 sont très espacé pour garantir un nombre exact des spires du capteur de mesure.

Pour éviter tout déplacement des spires lors de manipulations ou lors de fonctionnements avec des changement de température, ledit un bobinage comporte un enrobage pour fixer les spires à leur emplacements prévus. L'enrobage peut être réalisé avec des colles, des résines ou autre matériau avec ou sans recuit.

**Revendications**

1. Capteur de mesure (1) de courant de type tore de Rogowski comportant un support (2) en matériaux amagnétique et au moins un bobinage secondaire (3) enroulé sur ledit support pour fournir un signal électrique représentatif d'un courant circulant dans un conducteur traversant l'intérieur du tore, où ledit bobinage secondaire (3) comporte au moins deux couches (6, 7) dont les terminaisons électriques (14) des enroulements sont situées sur une même première extrémité (5) du bobinage, ledit bobinage comportant :

     - au moins une couche interne (6) à haute densité de spires proche du support (2) et enroulée dans un premier sens (10) d'enroulement de la première (5) extrémité vers une seconde extrémité (9) opposée du bobinage (3), et
     - au moins une couche externe (7) à faible densité de spires comportant au moins trois parties (12, 13, 14) et enroulée dans un second sens (11) d'enroulement de la seconde extrémité (9) opposée du bobinage vers la première extrémité (5), **caractérisé en ce que** ladite couche externe (7) à faible densité de spires comporte :

- une première partie (12) de compensation à haute densité de spires et de faible longueur (L1) proche de la première extrémité (5) du bobinage (3),
- une partie centrale (13) à faible densité de spires et de grande longueur (L2), et
- une seconde partie (14) de compensation à haute densité de spires et de faible longueur (L3) proche de la seconde extrémité (9) du bobinage (3),

ladite grande longueur (L2) de la partie centrale (13) étant supérieure à dix fois la somme des faibles longueurs (L1, L3) des parties (12, 14) à haute densité, et ladite haute densité de spires ayant un espacement entre spires inférieur au diamètre du fil d'enroulement du coté intérieur dudit tore, la faible densité de spires ayant un espacement entre spires supérieur au diamètre du fil de l'enroulement.

2. Capteur de mesure de courant selon la revendication 1 **caractérisé en ce que** ledit bobinage (3) comporte un nombre pair de couches (6, 106, 7, 107),

- une moitié des couches (6, 7) étant enroulées dans un premier sens (10) d'enroulement de la première extrémité (5) vers la seconde extrémité (9) opposée du bobinage, et
- l'autre moitié des couches (106, 107) étant enroulées dans un second sens (11) d'enroulement de la seconde extrémité (9) opposée du bobinage vers la première extrémité (5),
- la dernière couche (107) étant une couche externe à faible densité de spires enroulée dans ledit second sens (11) d'enroulement de la seconde extrémité (9) opposée du bobinage vers la première extrémité (5).

3. Capteur de mesure de courant selon l'une des revendications 1 ou 2 **caractérisé en ce que** ledit bobinage comporte un nombre pair de couches (6, 106, 7, 107) :

- une moitié des couches étant des couches internes (6, 106) à haute densité de spires proches du support, et
- l'autre moitié des couches étant des couches externes (7, 107) à faible densité de spires comportant trois parties,
- la dernière couche étant une couche externe (107) à faible densité de spires enroulée dans un second sens (11) d'enroulement de la seconde extrémité (9) opposée du bobinage à la première extrémité (5).

4. Capteur de mesure de courant selon l'une quelconque des revendications 1 à 3 **caractérisé en ce que** ledit bobinage comporte :

- une première couche interne (6) à haute densité de spires proche du support enroulée dans un premier sens (10) d'enroulement de la première extrémité (5) vers la seconde extrémité (9) opposée du bobinage,
- une seconde couche interne (106) à haute densité de spires proche du support enroulée dans un second sens (11) d'enroulement de la seconde extrémité (9) vers la première extrémité (5) opposée du bobinage,
- une première couche externe (7) à faible densité de spires comportant trois parties enroulée dans le premier sens (10) d'enroulement de la première extrémité (5) vers la seconde extrémité (9) opposée du bobinage, et
- une seconde couche externe (107) à faible densité de spires comportant trois parties enroulée dans un second sens (11) d'enroulement de la seconde extrémité (9) opposée du bobinage vers la première extrémité (5).

5. Capteur de mesure de courant selon l'une quelconque des revendications 1 à 4 **caractérisé en ce que** ledit bobinage comporte un enrobage pour fixer les spires à leur emplacement.

6. Procédé de bobinage d'un capteur de mesure de courant selon l'une quelconque des revendications 1 à 5 comportant :

- l'enroulement (30) d'au moins une couche interne (6) à haute densité de spires proche du support dans un premier sens (10) d'enroulement d'une première (5) extrémité vers une seconde extrémité (9) opposée du bobinage, et
- l'enroulement (31) d'au moins une couche externe (7) à faible densité de spires comportant trois parties dans un second sens (11) d'enroulement de la seconde (9) extrémité opposée du bobinage vers la première extrémité (5), **caractérisé en ce que** ladite couche externe comporte :

- une première partie (12) de compensation à haute densité de spires et de faible longueur (L1) proche de la première extrémité (5) du bobinage,
- une partie centrale (13) à faible densité de spires et de grande longueur (L2), et
- une seconde partie (14) de compensation à haute densité de spires et de faible longueur (L3) proche de la seconde extrémité (9) du bobinage,

ladite grande longueur (L2) de la partie centrale (13) étant supérieure à dix fois la somme des faibles longueurs (L1, L3) des parties (12, 14) à haute densité, et ladite haute densité de spires ayant un espacement entre spires inférieur au diamètre du fil d'enroulement du coté intérieur dudit tore, la faible densité de spires ayant un espacement entre spires supérieur au diamètre du fil de l'enroulement.

7. Procédé de bobinage selon la revendication 6 **caractérisé en ce qu'**il comporte des enroulements (32-37, 40-43) d'un nombre pair de couches,

    - une moitié des couches (32, 34, 40,42) étant enroulées dans un premier sens (10) d'enroulement de la première extrémité (5) vers la seconde extrémité opposée (9) du bobinage, et
    - l'autre moitié des couches (33, 36, 41, 43) étant enroulées dans un second sens (11) d'enroulement de la seconde extrémité (9) opposée du bobinage vers la première extrémité (5),
    - la dernière couche étant une couche externe (107) à faible densité de spires enroulée (37, 43) dans le second sens (11) d'enroulement de la seconde extrémité (9) opposée du bobinage vers la première extrémité (5).

8. Procédé de bobinage selon l'une des revendications 6 ou 7 **caractérisé en ce qu'**il comporte des enroulements (32-37) d'un nombre pair de couches,

    - une moitié (32, 33, 34) des couches étant des couches internes (6, 106) à haute densité de spires proches du support, et
    - l'autre moitié (35, 36, 37) des couches étant des couches externes (7, 107) à faible densité de spires,
    - la dernière couche (107) étant une couche externe à faible densité de spires enroulée (37, 43) dans le second sens (11) d'enroulement de la seconde extrémité (9) opposée du bobinage à la première extrémité (5).

9. Procédé de bobinage selon l'une quelconque des revendications 6 à 8 **caractérisé en ce qu'**il comporte :

    - l'enroulement (40) d'au moins une première couche (6) interne à haute densité de spires proche du support dans le premier sens (10) d'enroulement de la première extrémité (5) vers la seconde extrémité opposée (9) du bobinage,
    - l'enroulement (41) d'au moins une seconde couche interne (106) à haute densité de spires proche du support dans le second sens d'enroulement de la seconde (9) extrémité vers la première extrémité opposée (5) du bobinage,
    - l'enroulement (42) d'au moins une première couche externe (7) à faible densité de spires dans le premier sens (10) d'enroulement de la première extrémité (5) vers la seconde extrémité opposée (9) du bobinage, et
    - l'enroulement (43) d'au moins une seconde couche externe (107) à faible densité de spires dans le second sens (11) d'enroulement de la seconde extrémité (9) opposée du bobinage vers la première extrémité (5).

10. Dispositif (21) de mesure de courant comportant une unité de traitement (26) pour recevoir des signaux (I-e) représentatifs de courants électriques **caractérisé en ce qu'**il comporte un capteur de mesure (1) selon l'une quelconque des revendications 1 à 5 connecté à l'unité de traitement (26) pour fournir un signal (I-e) de courant représentatif d'un courant circulant dans un conducteur électrique.

11. Disjoncteur électrique (20) comportant au moins un contact principal (22) pour couper un courant dans un circuit électrique, un mécanisme (23) de commande de l'ouverture dudit contact électrique et un dispositif (21) de mesure et de protection fournissant un signal de commande (D) audit mécanisme de commande **caractérisée en ce qu'**il comporte un capteur (1) de mesure selon l'une quelconque des revendications 1 à 5 connecté à une unité de traitement (26) dudit dispositif (21) de mesure et de protection.

**Patentansprüche**

1. Strommesssensor (1) vom Typ Rogowski-Toroidspule, umfassend einen Träger (2) aus nichtmagnetischen Materialien und zumindest eine Sekundärspule (3), die auf den Träger gewickelt ist, um ein elektrisches Signal bereitzustellen, das repräsentativ für einen Strom ist, der in einem das Innere der Toroidspule durchdringenden Leiter fließt, wobei die Sekundärspule (3) zumindest zwei Schichten (6, 7) umfasst, deren elektrische Anschlüsse (14) der Wicklungen sich an einem selben ersten Ende (5) der Spule befinden, wobei die Spule Folgendes umfasst:

    - zumindest eine innere Schicht (6) mit hoher Windungsdichte nahe dem Träger (2), die in einer ersten Wicklungsrichtung (10) vom ersten Ende (5) zu einem entgegengesetzten zweiten Ende (9) der Spule (3) gewickelt ist, und
    - zumindest eine äußere Schicht (7) mit geringer Windungsdichte, die zumindest drei Abschnitte (12, 13, 14) umfasst und in einer zweiten Wicklungsrichtung (11) vom entgegengesetzten zweiten Ende (9) der Spule zum ersten Ende (5) gewickelt ist,

**dadurch gekennzeichnet, dass** die äußere Schicht (7) mit geringer Windungsdichte Folgendes umfasst:

- einen ersten Kompensationsabschnitt (12) mit hoher Windungsdichte und von geringer Länge (L1) nahe dem ersten Ende (5) der Spule (3),
- einen mittleren Abschnitt (13) mit geringer Windungsdichte und von großer Länge (L2) und
- einen zweiten Kompensationsabschnitt (14) mit hoher Windungsdichte und von geringer Länge (L3) nahe dem zweiten Ende (9) der Spule (3),

wobei die große Länge (L2) des mittleren Abschnitts (13) größer als das Zehnfache der Summe der geringen Längen (L1, L3) der Abschnitte (12, 14) mit hoher Dichte ist und wobei die hohe Windungsdichte einen Windungsabstand, der kleiner als der Durchmesser des Wicklungsdrahts ist, auf der Innenseite der Toroidspule aufweist, wobei die geringe Windungsdichte einen Windungsabstand aufweist, der größer als der Durchmesser des Wicklungsdrahts ist.

2. Strommesssensor nach Anspruch 1, **dadurch gekennzeichnet, dass** die Spule (3) eine gerade Anzahl an Schichten (6, 106, 7, 107) umfasst,

- wobei eine Hälfte der Schichten (6, 7) in einer ersten Wicklungsrichtung (10) vom ersten Ende (5) zum entgegengesetzten zweiten Ende (9) der Spule gewickelt ist und
- wobei die andere Hälfte der Schichten (106, 107) in einer zweiten Wicklungsrichtung (11) vom entgegengesetzten zweiten Ende (9) der Spule zum ersten Ende (5) gewickelt ist,
- wobei die letzte Schicht (107) eine äußere Schicht mit geringer Windungsdichte ist, die in der zweiten Wicklungsrichtung (11) vom entgegengesetzten zweiten Ende (9) der Spule zum ersten Ende (5) gewickelt ist.

3. Strommesssensor nach einem der Ansprüche 1 oder 2, **dadurch gekennzeichnet, dass** die Spule eine gerade Anzahl an Schichten (6, 106, 7, 107) umfasst,

- wobei eine Hälfte der Schichten innere Schichten (6, 106) mit hoher Windungsdichte nahe dem Träger sind und
- die andere Hälfte der Schichten äußere Schichten (7, 107) mit geringer Windungsdichte sind, die drei Abschnitte umfassen,
- wobei die letzte Schicht eine äußere Schicht (107) mit geringer Windungsdichte ist, die in einer zweiten Wicklungsrichtung (11) vom entgegengesetzten zweiten Ende (9) der Spule zum ersten Ende (5) gewickelt ist.

4. Strommesssensor nach einem der Ansprüche 1 bis 3 **dadurch gekennzeichnet, dass** die Spule Folgendes umfasst:

- eine erste innere Schicht (6) mit hoher Windungsdichte nahe dem Träger, die in einer ersten Wicklungsrichtung (10) vom ersten Ende (5) zum entgegengesetzten zweiten Ende (9) der Spule gewickelt ist,
- eine zweite innere Schicht (106) mit hoher Windungsdichte nahe dem Träger, die in einer zweiten Wicklungsrichtung (11) vom zweiten Ende (9) zum entgegengesetzten ersten Ende (5) der Spule gewickelt ist,
- eine erste äußere Schicht (7) mit geringer Windungsdichte, die drei Abschnitte umfasst und in der ersten Wicklungsrichtung (10) vom ersten Ende (5) zum entgegengesetzten zweiten Ende (9) der Spule gewickelt ist, und
- eine zweite äußere Schicht (107) mit geringer Windungsdichte, die drei Abschnitte umfasst und in einer zweiten Wicklungsrichtung (11) vom entgegengesetzten zweiten Ende (9) der Spule zum ersten Ende (5) gewickelt ist.

5. Strommesssensor nach einem der Ansprüche 1 bis 4, **dadurch gekennzeichnet, dass** die Spule einen Überzug umfasst, um die Windungen an ihrer Position zu fixieren.

6. Verfahren zur Wicklung eines Strommesssensors nach einem der Ansprüche 1 bis 5, umfassend:

- Wickeln (30) zumindest einer inneren Schicht (6) mit hoher Windungsdichte nahe dem Träger in einer ersten Wicklungsrichtung (10) von einem ersten Ende (5) zu einem entgegengesetzten zweiten Ende (9) der Spule und
- Wickeln (31) zumindest einer äußeren Schicht (7) mit geringer Windungsdichte, die drei Abschnitte umfasst, in einer zweiten Wicklungsrichtung (11) vom entgegengesetzten zweiten Ende (9) der Spule zum ersten Ende (5),

**dadurch gekennzeichnet, dass** die äußere Schicht Folgendes umfasst:

- einen ersten Kompensationsabschnitt (12) mit hoher Windungsdichte und von geringer Länge (L1) nahe dem ersten Ende (5) der Spule,
- einen mittleren Abschnitt (13) mit geringer Windungsdichte und von großer Länge (L2) und
- einen zweiten Kompensationsabschnitt (14) mit hoher Windungsdichte und von geringer Länge (L3) nahe dem zweiten Ende (9) der Spule,

wobei die große Länge (L2) des mittleren Abschnitts (13) größer als das Zehnfache der Summe der geringen Längen (L1, L3) der Abschnitte (12, 14) mit hoher Dichte ist und
wobei die hohe Windungsdichte einen Windungsabstand, der kleiner als der Durchmesser des Wicklungsdrahts ist, auf der Innenseite der Toroidspule aufweist, wobei die geringe Windungsdichte einen Windungsabstand aufweist, der größer als der Durchmesser des Wicklungsdrahts ist.

7. Wicklungsverfahren nach Anspruch 6, **dadurch gekennzeichnet, dass** es Wicklungen (32 - 37, 40 - 43) mit einer geraden Anzahl an Schichten umfasst,

- wobei eine Hälfte der Schichten (32, 34, 40, 42) in einer ersten Wicklungsrichtung (10) vom ersten Ende (5) zum entgegengesetzten zweiten Ende (9) der Spule gewickelt ist und
- die andere Hälfte der Schichten (33, 36, 41, 43) in einer zweiten Wicklungsrichtung (11) vom entgegengesetzten zweiten Ende (9) der Spule zum ersten Ende (5) gewickelt ist,
- wobei die letzte Schicht eine äußere Schicht (107) mit geringer Windungsdichte ist, die in der zweiten Wicklungsrichtung (11) vom entgegengesetzten zweiten Ende (9) der Spule zum ersten Ende (5) gewickelt ist (37, 43).

8. Wicklungsverfahren nach einem der Ansprüche 6 oder 7, **dadurch gekennzeichnet, dass** es Wicklungen (32 - 37) mit einer geraden Anzahl an Schichten umfasst,

- wobei eine Hälfte (32, 33, 34) der Schichten innere Schichten (6, 106) mit hoher Windungsdichte nahe dem Träger sind und
- die andere Hälfte (35, 36, 37) der Schichten äußere Schichten (7, 107) mit geringer Windungsdichte sind,
- wobei die letzte Schicht (107) eine äußere Schicht mit geringer Windungsdichte ist, die in der zweiten Wicklungsrichtung (11) vom entgegengesetzten zweiten Ende (9) der Spule zum erste Ende (5) gewickelt ist (37, 43).

9. Wicklungsverfahren nach einem der Ansprüche 6 bis 8, **dadurch gekennzeichnet, dass** es Folgendes umfasst:

- Wickeln (40) zumindest einer ersten inneren Schicht (6) mit hoher Windungsdichte nahe dem Träger in der ersten Wicklungsrichtung (10) vom ersten Ende (5) zum entgegengesetzten zweiten Ende (9) der Spule,
- Wickeln (41) zumindest einer zweiten inneren Schicht (106) mit hoher Windungsdichte nahe dem Träger in der zweite Wicklungsrichtung vom zweiten Ende (9) zum entgegengesetzten ersten Ende (5) der Spule,
- Wickeln (42) zumindest einer ersten äußeren Schicht (7) mit geringer Windungsdichte in der ersten Wicklungsrichtung (10) vom ersten Ende (5) zum entgegengesetzten zweiten Ende (9) der Spule und
- Wickeln (43) zumindest einer zweiten äußeren Schicht (107) mit geringer Windungsdichte in der zweiten Wicklungsrichtung (11) vom entgegengesetzten zweiten Ende (9) der Spule zum ersten Ende (5).

10. Strommessvorrichtung (21), umfassend eine Verarbeitungseinheit (26) zum Empfangen von Signalen (I-e), die für elektrische Ströme repräsentativ sind, **dadurch gekennzeichnet, dass** sie einen Messsensor (1) nach einem der Ansprüche 1 bis 5 umfasst, der mit der Verarbeitungseinheit (26) verbunden ist, um ein Stromsignal (I-e) bereitzustellen, das für einen in einem elektrischen Leiter fließenden Strom repräsentativ ist.

11. Elektrischer Trennschalter (20), umfassend zumindest einen Hauptkontakt (22) zum Unterbrechen eines Stroms in einer elektrischen Schaltung, einen Mechanismus (23) zur Steuerung der Öffnung des elektrischen Kontakts und eine Mess- und Schutzvorrichtung (21), die ein Steuersignal (D) an den Steuermechanismus bereitstellt, **dadurch gekennzeichnet, dass** er einen Messsensor (1) nach einem der Ansprüche 1 bis 5 umfasst, der mit einer Verarbeitungseinheit (26) der Mess- und Schutzvorrichtung (21) verbunden ist.

**Claims**

1. Current measurement sensor (1) of the Rogowski coil type comprising a carrier (2) made of non-magnetic material and at least one secondary winding (3) wound on the said carrier in order to supply an electrical signal representative of a current flowing in a conductor passing through the inside of the coil, wherein the said secondary winding (3) comprises at least two layers (6, 7) the electrical terminations (14) of whose windings are situated on one and the same first end (5) of the winding, the said winding comprising:

- at least one internal layer (6) with a high turn density close to the carrier (2) and wound in a first direction (10) of winding from the first (5) end towards a second opposite end (9) of the winding (3), and

- at least one external layer (7) with a low turn density comprising at least three portions (12, 13, 14) and wound in a second direction (11) of winding from the second opposite end (9) of the winding towards the first end (5), **characterized in that** the said external layer (7) with a low turn density comprises:

- a first compensation portion (12) with a high turn density and of small length (L1) close to the first end (5) of the winding (3),
- a central portion (13) with a low turn density and of large length (L2), and
- a second compensation portion (14) with a high turn density and of small length (L3) close to the second end (9) of the winding (3),
- the said large length (L2) of the central portion (13) being greater than ten times the sum of the small lengths (L1, L3) of the high-density portions (12, 14), and the said high turn density having a spacing between turns less than the diameter of the winding wire on the inside of the said coil, the low turn density having a spacing between turns greater than the diameter of the wire of the winding.

2. Current measurement sensor according to Claim 1, **characterized in that**, the said winding (3) comprises an even number of layers (6, 106, 7 ,107),

- one half of the layers (6, 7) being wound in a first direction (10) of winding from the first end (5) towards the second opposite end (9) of the winding, and
- the other half of the layers (106, 107) being wound in a second direction (11) of winding from the second opposite end (9) of the winding towards the first end (5),
- the last layer (107) being an external layer with a low turn density wound in the said second direction (11) of winding from the second opposite end (9) of the winding towards the first end (5).

3. Current measurement sensor according to one of Claims 1 and 2, **characterized in that** the said winding comprises an even number of layers (6, 106, 7 ,107):

- one half of the layers being internal layers (6, 106) with a high turn density close to the carrier, and
- the other half of the layers being external layers (7, 107) with a low turn density comprising three portions,
- the last layer being an external layer (107) with a low turn density wound in a second direction (11) of winding from the second opposite end (9) of the winding to the first end (5).

4. Current measurement sensor according to any one of Claims 1 to 3, **characterized in that** the said winding comprises:

- a first internal layer (6) with a high turn density close to the carrier wound in a first direction (10) of winding from the first end (5) towards the second opposite end (9) of the winding,
- a second internal layer (106) with a high turn density close to the carrier wound in a second direction (11) of winding from the second end (9) towards the first opposite end (5) of the winding,
- a first external layer (7) with a low turn density comprising three portions wound in the first direction (10) of winding of the first end (5) towards the second opposite end (9) of the winding, and
- a second external layer (107) with a low turn density comprising three portions wound in a second direction (11) of winding from the second opposite end (9) of the winding towards the first end (5).

5. Current measurement sensor according to any one of Claims 1 to 4, **characterized in that** the said winding comprises a coating for fixing the turns in their position.

6. Winding method for a current measurement sensor according to any one of Claims 1 to 5, comprising:

- the winding (30) of at least one internal layer (6) with a high turn density close to the carrier in a first direction (10) of winding from a first end (5) towards a second opposite end (9) of the winding, and
- the winding (31) of at least one external layer (7) with a low turn density comprising three portions in a second direction (11) of winding from the second (9) opposite end of the winding towards the first end (5), **characterized in that** the said external layer comprises:

- a first compensation portion (12) with a high turn density and of small length (L1) close to the first end (5) of the winding,
- a central portion (13) with a low turn density and of large length (L2), and
- a second compensation portion (14) with a high turn density and of small length (L3) close to the second end (9) of the winding,
- the said large length (L2) of the central portion (13) being greater than ten times the sum of the small lengths (L1, L3) of the high-density portions (12, 14), and the said high turn density having a spacing between turns less than the diameter of the winding wire on the inside of the said coil, the low turn density having a spacing between turns greater than the diameter of the wire of the winding.

7. Winding method according to Claim 6, **characterized in that** it comprises windings (32-37, 40-43) with an even number of layers,

- one half of the layers (32, 34, 40, 42) being wound in a first direction (10) of winding from the first end (5) towards the second opposite end (9) of the winding, and
- the other half of the layers (33, 36, 41, 43) being wound in a second direction (11) of winding from the second opposite end (9) of the winding towards the first end (5),
- the last layer being an external layer (107) with a low turn density wound (37, 43) in the second direction (11) of winding from the second opposite end (9) of the winding towards the first end (5).

8. Winding method according to either of Claims 6 and 7, **characterized in that** it comprises windings (32-37) with an even number of layers,

- one half (32, 33, 34) of the layers being internal layers (6, 106) with a high turn density close to the carrier, and
- the other half (35, 36, 37) of the layers being external layers (7, 107) with a low turn density,
- the last layer (107) being an external layer with a low turn density wound (37, 43) in the second direction (11) of winding from the second opposite end (9) of the winding to the first end (5).

9. Winding method according to any one of Claims 6 to 8, **characterized in that** it comprises:

- the winding (40) of at least a first internal layer (6) with a high turn density close to the carrier in the first direction (10) of winding from the first end (5) towards the second opposite end (9) of the winding,
- the winding (41) of at least a second internal layer (106) with a high turn density close to the carrier in the second winding direction from the second end (9) towards the first opposite end (5) of the winding,
- the winding (42) of at least a first external layer (7) with a low turn density in the first direction (10) of winding from the first end (5) towards the second opposite end (9) of the winding, and
- the winding (43) of at least a second external layer (107) with a low turn density in the second direction (11) of winding from the second opposite end (9) of the winding towards the first end (5).

10. Current measurement device (21) comprising a processing unit (26) for receiving signals (I-e) representative of electrical currents **characterized in that** it comprises a measurement sensor (1) according to any one of Claims 1 to 5 connected to the processing unit (26) for supplying a current signal (I-e) representative of a current flowing in an electrical conductor.

11. Electrical circuit breaker (20) comprising at least one main contact (22) for interrupting a current in an electrical circuit, a mechanism (23) for controlling the opening of the said electrical contact and a measurement and protection device (21) supplying a control signal (D) to the said control mechanism **characterized in that** it comprises a measurement sensor (1) according to any one of Claims 1 to 5 connected to a processing unit (26) of the said measurement and protection device (21).

**FIG. 1**

**FIG. 2**

FIG. 3

FIG. 4

**FIG. 5**

**FIG. 6**

Enroulement dans le sens aller d'une première couche interne à haute densité de spires.

30

Enroulement dans le sens retour d'une seconde couche externe à faible densité et à trois parties comportant :
- une première partie de compensation à haute densité de spires et de faible longueur proche de la première extrémité du bobinage,
- une partie centrale à faible densité de spires et de grande longueur, et
- une seconde partie de compensation à haute densité de spires et de faible longueur proche de la seconde extrémité du bobinage.

31

## FIG. 7

## FIG. 8

Enroulement dans le sens aller d'une première couche interne à haute densité de spires.

32

Enroulement dans le sens retour d'une seconde couche interne à haute densité de spires

33

Enroulement dans le sens aller ou retour d'autres couches internes à haute densité de spires

34

Enroulement dans un sens opposé au sens précédent d'une première couche externe à faible densité

35

Enroulement dans un sens opposé au sens précédent d'une seconde couche externe à faible densité

36

Enroulement dans un sens opposé au sens précédent d'un nombre de couches externe à faible densité identique au nombre de couche internes à haute densité.

37

Enroulement dans le sens aller d'une première couche interne à haute densité de spires.

40

Enroulement dans le sens retour d'une seconde couche interne à haute densité de spires.

41

Enroulement dans le sens aller d'une troisième couche qui est une première couche externe à faible densité et à trois parties

42

Enroulement dans le sens retour d'une quatrième couche qui est une seconde couche externe à faible densité et à trois parties

43

**FIG. 9**

6

7

13

**FIG. 10**

**EP 3 290 930 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2667205 A1
- US 2014132249 A1
- US 2008079418 A
- US 2015028853 A
- US 2011043190 A